# EUROPÄISCHE PATENTSCHRIFT

(11) **EP 3 867 992 B1**
(45) Veröffentlichungstag und Bekanntmachung des Hinweises auf die Patenterteilung: **12.10.2022**
(21) Anmeldenummer: 19787248.4
(22) Anmeldetag: 15.10.2019
(51) Int. Cl.: H02J 7/00

(54) **BATTERIEZELLE MIT INTEGRIERTEM STEUERSCHALTKREIS**
BATTERY CELL WITH AN INTEGRATED CONTROL CIRCUIT
CELLULE DE BATTERIE AVEC CIRCUIT DE COMMANDE INTÉGRÉ

(30) Priorität: 15.10.2018 DE 102018217572
(43) Veröffentlichungstag der Anmeldung: 25.08.2021
(73) Patentinhaber: Robert Bosch GmbH, 70442 Stuttgart (DE)
(72) Erfinder: GRABOWSKI, Johannes, 72762 Reutlingen (DE); JOOS, Joachim, 70839 Gerlingen (DE); VON EMDEN, Walter, 72800 Eningen Unter Achalm (DE)
(86) Internationale Anmeldenummer: PCT/EP2019/077833
(87) Internationale Veröffentlichungsnummer: WO 2020/078935

(56) Entgegenhaltungen:
- DE-A1-102015 002 149
- US-A1- 2015 303 442

## Beschreibung

### Stand der Technik

Die vorliegende Erfindung betrifft eine Batteriezelle mit integriertem Steuerschaltkreis.

Zur Erfüllung von Anforderungen an Batteriesysteme ist oftmals ein Aufbau von Parallel- und Serienschaltungen von Einzelzellen, beispielsweise von Lithiumionenzellen, notwendig. Dabei ist es bekannt, dass eine Batteriezelle einen Steuerschaltkreis umfasst, um einen Stromfluss in der Batteriezelle zu unterbrechen.

So offenbart die DE 102015002149 A1 eine Batteriezelle mit zumindest einem Schaltelement, welches dazu geeignet ist, einen Stromfluss durch die Batteriezelle zu unterbrechen, wenn die Batteriezelle sich in einem kritischen Zustand befindet. Ferner ist aus der US 20150303442 A1 eine Batteriezelle mit einer Steuereinheit bekannt, wobei durch zwei in der Batteriezelle angeordnete Schalter eine Energieabgabe der Batteriezelle unterbrochen werden kann.

### Offenbarung der Erfindung

Die erfindungsgemäße Batteriezelle gemäß Anspruch 1 umfasst einen ersten Anschlusskontakt, einen zweiten Anschlusskontakt, einen Energiespeicher, einen ersten Transistor, eine Sensorik, welche dazu eingerichtet ist, einen Zustandsparameter der Batteriezelle zu erfassen, und einen Steuerschaltkreis, wobei ein erster Pol des Energiespeichers mit dem ersten Anschlusskontakt gekoppelt ist und ein zweiter Pol des Energiespeichers mit dem zweiten Anschlusskontakt gekoppelt ist, wobei der erste Transistor zwischen dem ersten Anschlusskontakt und dem zweiten Anschlusskontakt mit dem Energiespeicher in Reihe geschaltet ist, und wobei der Steuerschaltkreis dazu eingerichtet ist, einen Schaltvorgang des ersten Transistors zu steuern, wobei der Steuerschaltkreis den ersten Transistor basierend auf dem erfassten Zustandsparameter steuert, um einen Ladestrom oder einen Entladestrom des Energiespeichers zu regeln.

Der erste Anschlusskontakt und der zweite Anschlusskontakt sind äußere Anschlusskontakte der Batteriezelle, welche insbesondere dazu geeignet sind, die Batteriezelle mit anderen Batteriezellen zu verschalten, beispielsweise in Serie oder parallel zu schalten. Der Energiespeicher ist insbesondere ein elektrochemischer Speicher, beispielsweise eine Lithiumionenzelle. Die Sensorik ist eine Messvorrichtung, die dazu eingerichtet ist, den Zustandsparameter zu messen. Die Sensorik umfasst dazu insbesondere einen Sensor. Der Steuerschaltkreis ist bevorzugt ein integrierter Schaltkreis, beispielsweise ein ASIC. Der Steuerschaltkreis ist insbesondere über eine Steuerleitung mit dem ersten Transistor verbunden, um diesen zu schalten. Der erste Pol des Energiespeichers ist entweder ein positiver Pol oder ein negativer Pol. Der zweite Pol des Energiespeichers ist der jeweils andere des positiven Pols oder des negativen Pols.

Der erste Transistor ist zwischen dem ersten Anschlusskontakt und dem zweiten Anschlusskontakt mit dem Energiespeicher in Reihe geschaltet. Das bedeutet, dass der erste Transistor entweder zwischen dem Energiespeicher und dem ersten Anschlusskontakt oder zwischen dem Energiespeicher und dem zweiten Anschlusskontakt geschaltet ist. Die Batteriezelle umfasst somit einen direkt auf der Batteriezelle verbauten leistungselektronischen Schalter als Teil der einzelnen Batteriezelle.

Der Steuerschaltkreis ist dazu eingerichtet, einen Schaltvorgang des ersten Transistors zu steuern, wobei der Steuerschaltkreis den Transistor basierend auf dem erfassten Zustandsparameter steuert, um einen Ladestrom oder einen Entladestrom des Energiespeichers zu regeln. Das Regeln von Ladestrom und Entladestrom bedeutet dabei, dass ein dem Energiespeicher zugeführter Strom oder ein dem Energiespeicher entnommener Strom dynamisch geregelt wird. Das bedeutet, dass durch den Schaltvorgang des ersten Transistors gesteuert werden kann, wie groß ein bestimmter Stromfluss über eine bestimmte Zeit ist. Ein Regeln beschränkt sich somit nicht auf ein ledigliches An- und Abschalten eines Stroms, sondern definiert eine quantitative Bestimmung des Ladestroms oder des Entladestroms. Der Ladestrom und der Entladestrom können somit auf bestimmte Stromgrößen eingestellt werden, es können somit durch das Regeln unterschiedlich starke Ladeströme und/oder unterschiedlich starke Entladeströme eingestellt werden. Bevorzugt bildet die Sensorik mit dem Steuerschaltkreis und dem ersten Transistor einen Regelkreis.

Es wird somit eine gezielte Stromregelung innerhalb der Batteriezelle geschaffen. Diese basiert dabei auf einem Zustandsparameter, der ebenfalls innerhalb der Batteriezelle erfasst wurde. Durch die Batteriezelle kann somit eine eigenständige Regelung des Ladestroms oder des Entladestroms erfolgen, je nachdem, in welchem Zustand die Batteriezelle sich befindet, also ob die Batteriezelle sich in einem Ladezustand oder in einem Entladezustand befindet. Es wird somit ein besonders kompaktes System geschaffen, wobei insbesondere durch kurze Mess- und Regelwege eine besonders genaue Einstellung eines Ladestroms und/oder eines Entladestroms basierend auf zumindest einem lokal erfassten Zustandsparameter erfolgen kann. Es wird somit eine autonom arbeitende Batteriezelle geschaffen.

Zur Erfüllung von Anforderungen an Batteriesysteme der Zukunft ist ein Aufbau von Parallel und Serienschaltung von z.B. Li-Ion Einzelzellen notwendig. Die Möglichkeit den Stromfluss einzelner Batteriezellen zu kontrollieren, also einzelne Batteriezellen zu zuschalten bzw. zu überbrücken ist vorteilhalft in Hinblick auf viele Schlüsselfaktoren bzgl. Leistungsfähigkeit der Gesamtbatterie. Die betrifft z.B. Sicherheitsfunktionen, die Möglichkeit des (getakteten) Schnellladens einzelner Zellen (je nach Lade- (SOC) und Zuverlässigkeitsstatus (SOH)), und der unterschiedlichen Belastung im Betrieb einzelner Zellen (jeweils wieder abhängig vom SOC und SOH).

Es wird ein Leistungsmodul-bzw. Aufbau und Verbindungstechnik-Konzept für die Kosten-und Bauraum-optimierte Realisierung des Modules auf Zellebene einer Batterie geschaffen.

Die Unteransprüche zeigen bevorzugte Weiterbildungen der Erfindung.

Bevorzugt umfasst die Sensorik zumindest eines aus einem Spannungssensor, einen Stromsensor und einem Temperatursensor. Durch die Sensorik wird somit entweder eine Spannung, ein Strom oder eine Temperatur in der Batteriezelle erfasst. Dabei wird durch den Spannungssensor bevorzugt eine Spannung des Energiespeichers gemessen. Durch den Stromsensor wird bevorzugt der Ladestrom oder der Entladestrom des Energiespeichers gemessen. Durch den Temperatursensor wird bevorzugt eine Temperatur des Energiespeichers gemessen. Dazu ist der Temperatursensor bevorzugt an dem Energiespeicher angeordnet. Es kann somit ein Status der Batteriezelle erfasst werden, da durch die Sensorik solche Parameter erfasst werden, welche den Zustand der Batteriezelle genau beschreiben und ein vorteilhafter Ladestrom oder Entladestrom auf den von einer solchen Sensorik erfassten Messwerten besonders präzise geregelt werden kann.

Auch ist es vorteilhaft, wenn der erste Transistor ein Dünnfilm-MOSFET Transistor ist. Dies erlaubt es, eine besonders kompakte Batteriezelle zu schaffen. Dabei ist der Dünnfilm-MOSFET Transistor besonders vorteilhaft, da dieser eine Wärmeleistung durch seine Oberfläche besonders schnell in ein Umfeld der Batteriezelle abgeben kann. Auch kann ein solcher Dünnfilm-MOSFET besonders vorteilhaft auf einer Oberfläche der Batteriezelle angeordnet werden. Dies ist insbesondere dann vorteilhaft, wenn die Batteriezelle eine prismatische Zelle ist, da eine solche prismatische Zelle typischerweise eine Oberfläche aufweist, die hinreichend groß ist, um einen Dünnfilm-MOSFET Transistor zum Regeln eines Ladestroms oder Entladestroms auf diese anzuordnen. Auch ist die insbesondere dann vorteilhaft, wenn die Batteriezelle eine Pouch-Zelle ist, damit ein besonders flacher Aufbau der Batteriezelle erreicht werden kann.

Erfindungsgemäß umfasst die Batteriezelle ferner einen zweiten Transistor, welcher zwischen dem ersten Anschlusskontakt und dem zweiten Anschlusskontakt parallel zu dem Energiespeicher geschaltet ist, wobei der Steuerschaltkreis dazu eingerichtet ist, einen Schaltvorgang des zweiten Transistors zu steuern, und wobei der zweite Transistor insbesondere ein Dünnfilm-MOSFET Transistor ist. Durch den zweiten Transistor wird es ermöglicht, dass die Anschlusskontakte der Batteriezelle miteinander kurzgeschlossen werden können, wenn der erste Transistor ein entsprechendes Steuersignal von der Steuereinheit empfängt. Somit kann die Batteriezelle gebrückt werden, beispielsweise um in einer Reihenschaltung mehrerer Batteriezellen inaktiv zu sein, ohne die Reihenschaltung zu unterbrechen. Gleichzeitig kann durch ein entsprechendes Schalten des zweiten Transistors durch den Steuerschaltkreis ein gezieltes Entladen des Energiespeichers mit einem gewünschten Entladestrom erfolgen. Die Ausführung des zweiten Transistors als Dünnfilm-MOSFET Transistor ermöglicht einen besonders kompakten Aufbau der Batteriezelle. Dabei ist es besonders vorteilhaft, wenn sowohl der erste Transistor als auch der zweite Transistor als Dünnfilm-MOSFET Transistor ausgeführt sind.

Erfindungsgemäß ist der Steuerschaltkreis dazu eingerichtet, sowohl den ersten Transistor als auch den zweiten Transistor gleichzeitig in einen leitenden Zustand zu schalten. Dabei kann ein Stromfluss durch den ersten Transistor und/oder durch den zweiten Transistor geregelt werden. Auf diese Weise wird es ermöglicht, dass die Batteriezelle beheizt wird, was beispielsweise vorteilhaft ist, um den Energiespeicher auf eine Arbeitstemperatur oder eine bevorzugte Temperatur für ein Balancing zu regeln. Dabei ist es insbesondere vorteilhaft, wenn der Zustandsparameter eine Temperatur ist und die Sensorik einen Temperatursensor umfasst. Es kann somit in der Batteriezelle eine autonom arbeitende Temperaturregelung erfolgen.

Ferner ist es vorteilhaft, wenn der Steuerschaltkreis dazu eingerichtet ist, den Schaltvorgang des ersten Transistors zum Regeln des Ladestroms oder des Entladestroms durch ein gepulstes Schalten des Transistors oder durch ein Betreiben des ersten Transistors in einem Widerstandsbetrieb zu regeln. So werden der erste Transistor und/oder der zweite Transistor durch ein pulsweites moduliertes Signal angesteuert, um diesen gepulst zu schalten. Durch ein Einstellen der Pulsweite oder Frequenz durch den Steuerschaltkreis kann der Ladestrom und/oder der Entladestrom geregelt werden. Dies ist besonders vorteilhaft, da dies ein besonders schnelles Laden des Energiespeichers ermöglicht, wobei die Batteriezelle nicht unnötig erwärmt wird, da der erste Transistor nicht als Widerstand arbeitet. Wird der erste Transistor in einem Widerstandsbetrieb betrieben, so ist dies ebenfalls vorteilhaft, da der Ladestrom und der Entladestrom in analoger Weise besonders genau eingestellt werden kann.

Ferner ist es vorteilhaft, wenn der Steuerschaltkreis dazu eingerichtet ist, den Schaltvorgang des ersten Transistors zum Regeln des Ladestroms oder des Entladestroms so anzusteuern, dass ein Cell-Balancing ausgeführt wird. Dabei ist der erste Zustandsparameters bevorzugt eine Spannung des Energiespeichers und die Spannung des Energiespeichers wird durch Regeln des Entladestroms und des Ladestroms auf einen Zielwert eingestellt. Weiter bevorzugt wird das Cell-Balancing basierend auf Messwerten ausgeführt, welche einen Zustand benachbarter Batteriezellen beschreiben. Dabei wird bevorzugt aus dem Zustandsparameter auf einen Zustand benachbarter Batteriezellen geschlossen. So wird durch den Zustandsparameter insbesondere eine in der Batteriezelle vorliegende Spannung oder ein durch die Batteriezelle fließender Strom gemessen, welcher durch benachbarte Batteriezellen bereitgestellt wird. Alternativ wird der Steuereinheit eine Information über einen Ladezustand benachbarter Batteriezellen über eine zusätzliche Schnittstelle bereitgestellt. Es kann somit ein Cell-Balancing ohne eine zentrale Steuereinheit zum Ansteuern des Ladestroms und des Entladestroms in den Batteriezellen einer Batterie erfolgen. Es wird ein besonders fehlerresistentes System geschaffen.

Auch ist es vorteilhaft, wenn der Steuerschaltkreis dazu eingerichtet ist, einen Ladezustand des Energiespeichers, einen Alterungszustand des Energiespeichers und/oder einen Funktionszustand des Energiespeichers zu ermitteln. Dabei werden der Ladezustand, der Alterungszustand und/oder der Funktionszustand basierend auf dem Zustandsparameter ermittelt. Es wird somit eine besonders aussagekräftige Basis geschaffen, die ein vorteilhaftes Regeln des Ladestroms und/oder des Entladestroms, insbesondere bei einem Cell-Balancing, ermöglicht.

Bevorzugt ist der erste Transistor auf einer äußeren Oberfläche des Energiespeichers angeordnet, wobei eine erste Kontaktoberfläche des ersten Transistors auf dem zweiten Pol des Energiespeichers aufliegt, wobei ein plattenförmiger Leiter auf einer zweiten Kontaktoberfläche des ersten Transistors aufliegt, welche der äußeren Oberfläche des Energiespeichers abgewandt ist, und wobei der plattenförmige Leiter mit dem zweiten Anschlusskontakt elektrisch verbunden ist. Die erste Kontaktoberfläche des ersten Transistors und die zweite Kontaktoberfläche des ersten Transistors sind solche Oberflächen des ersten Transistors, zwischen denen durch ein Schalten des Transistors ein Kontakt geschaltet wird. Ein plattenförmiger Leiter ist ein Leiter, welcher zumindest eine flächige Oberfläche aufweist. Im einfachsten Falle bedeutet dies, dass der plattenförmige Leiter nicht rund ist und ebenflächig auf dem ersten Transistor aufliegt. Es wird somit eine großflächige Kontaktfläche zwischen der Kontaktoberfläche des ersten Transistors und dem Pol des Energiespeichers geschaffen. Es wird zugleich eine besonders kompakte Bauweise der Batteriezelle ermöglicht und ein Stromfluss mit geringem Widerstand ermöglicht. Zudem kann in der Batteriezelle ein effizienter Temperaturausgleich über die Kontaktoberflächen erfolgen, um eine Überhitzung des ersten Transistors und des Energiespeichers zu vermeiden.

Dabei ist es vorteilhaft, wenn ein weiterer Transistor auf der äußeren Oberfläche des Energiespeichers angeordnet ist, wobei eine erste Kontaktoberfläche des weiteren Transistors auf dem ersten Pol des Energiespeichers aufliegt, und wobei der plattenförmige Leiter ferner auf einer zweiten Kontaktoberfläche des weiteren Transistors aufliegt, welche der äußeren Oberfläche des Energiespeichers abgewandt ist. Der weitere Transistor ist bevorzugt der zweite Transistor. Es wird somit ermöglicht, dass sowohl der erste Transistor als auch der weitere Transistor über ein einzelnes gemeinsames Element, hier den plattenförmigen Leiter, kontaktiert werden. Es wird somit ein besonders einfacher Aufbau der Batteriezelle geschaffen.

Es wird darauf hingewiesen, dass sowohl das Schalten des ersten Transistors als auch das Schalten des zweiten Transistors durch den Steuerschaltkreis bevorzugt basierend auf dem erfassten Zustandsparameter der Batteriezelle erfolgt. Dies schließt jedoch nicht aus, dass zusätzlich zu dem Zustandsparameter der Batteriezelle noch weitere Parameter hinzugezogen werden, beispielsweise Parameter, die dem Steuerschaltkreis mittels einer Kommunikationsschnittstelle bereitgestellt werden.

### Kurze Beschreibung der Zeichnungen

Nachfolgend werden Ausführungsbeispiele der Erfindung unter Bezugnahme auf die begleitende Zeichnung im Detail beschrieben. In der Zeichnung ist:
- Figur 1: ein Schaltbild einer Batteriezelle gemäß einer ersten Ausführungsform der Erfindung,
- Figur 2: ein Schaltbild einer Batteriezelle gemäß einer zweiten Ausführungsform der Erfindung,
- Figur 3: ein Schaltbild eines beispielhaften Steuerschaltkreises gemäß einer Ausführungsform der Erfindung,
- Figur 4: eine Darstellung der Batteriezelle gemäß einer Ausführungsform der Erfindung in einem beispielhaften ersten Betriebsmodus,
- Figur 5: eine Darstellung der Batteriezelle gemäß einer Ausführungsform der Erfindung in einem beispielhaften zweiten Betriebsmodus,
- Figur 6: eine Darstellung einer Serienschaltung mehrerer Batteriezellen gemäß einer Ausführungsform der Erfindung,
- Figur 7: eine Darstellung der Batteriezelle gemäß einer Ausführungsform der Erfindung in einem beispielhaften dritten Betriebsmodus,
- Figur 8: eine Darstellung der Batteriezelle gemäß einer Ausführungsform der Erfindung in einem beispielhaften vierten Betriebsmodus,
- Figur 9: eine Darstellung der Batteriezelle gemäß einer Ausführungsform der Erfindung in einem beispielhaften fünften Betriebsmodus,
- Figur 10: eine Darstellung einer erfindungsgemäßen Batteriezelle in einer ersten Ansicht, und
- Figur 11: eine Darstellung der erfindungsgemäßen Batteriezelle in einer zweiten Ansicht.

### Ausführungsform der Erfindung

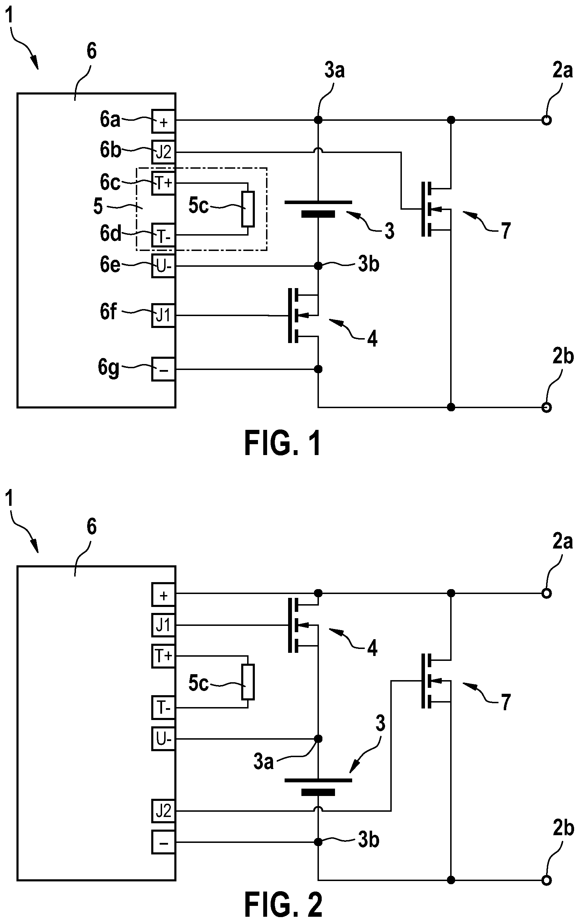

Figur 1 zeigt ein Schaltbild einer Batteriezelle 1 gemäß einer ersten Ausführungsform der Erfindung. Die Batteriezelle 1 umfasst einen ersten Anschlusskontakt 2a und einen zweiten Anschlusskontakt 2b. Die beiden Anschlusskontakte 2a, 2b ermöglichen es, einen Verbraucher an die Batteriezelle 1 anzuschließen oder weitere Batterien oder Batteriezellen mit der Batteriezelle 1 in Serie oder parallel zu schalten.

Die Batteriezelle 1 umfasst einen Energiespeicher 3. Der Energiespeicher 3 ist ein elektrochemischer Energiespeicher, wobei der Energiespeicher 3 in dieser ersten Ausführungsform der Erfindung bevorzugt eine Lithiumionenzelle ist. Der Energiespeicher 3 weist einen ersten Pol 3a und einen zweiten Pol 3b auf. Dabei ist der erste Pol 3a ein Pluspol und der zweite Pol 3b ein Minuspol. Es wird jedoch darauf hingewiesen, dass in alternativen Ausführungsformen der erste Pol 3a ein Minuspol und der zweite Pol 3b ein Pluspol ist. Der erste Pol 3a des Energiespeichers 3 ist mit dem ersten Anschlusskontakt 2a verbunden.

Die Batteriezelle 1 umfasst ferner einen ersten Transistor 4. Der erste Transistor 4 ist ein Dünnfilm-MOSFET Transistor. Der erste Transistor 4 weist einen ersten Schaltkontakt und einen zweiten Schaltkontakt auf, wobei der erste Schaltkontakt mit dem zweiten Pol 3b des Energiespeichers 3 verbunden ist und der zweite Schaltkontakt mit dem zweiten Anschlusskontakt 2b verbunden ist. Der erste Schaltkontakt ist ein Source-Kontakt des Transistors. Der zweite Schaltkontakt ist ein Drain-Kontakt des ersten Transistors 4. Der erste Transistor 4 weist ferner einen Steuerkontakt auf, wobei der Steuerkontakt in dieser ersten Ausführungsform der Erfindung ein Gatekontakt ist.

Die Batteriezelle 1 umfasst ferner einen Steuerschaltkreis 6, welcher ein ASIC ist. Der Steuerschaltkreis 6 ist somit ein integrierter Schaltkreis. Der Steuerschaltkreis 6 weist einen ersten Anschluss 6a, einen zweiten Anschluss 6b, einen dritten Anschluss 6c, einen vierten Anschluss 6d, einen fünften Anschluss 6e, einen sechsten Anschluss 6f und einen siebten Anschluss 6g auf. Über den ersten bis siebten Anschluss können dem Steuerschaltkreis 6 Eingangssignale bereitgestellt werden und kann der Steuerschaltkreis 6 Ausgangssignale ausgeben.

Die Batteriezelle 1 weist ferner einen zweiten Transistor 7 auf. Der zweite Transistor 7 ist ein Dünnfilm-MOSFET Transistor. Der zweite Transistor 7 ist zwischen dem ersten Anschlusskontakt und dem zweiten Anschlusskontakt 2b parallel zu dem Energiespeicher 3 geschaltet. Dazu ist ein erster Schaltkontakt des zweiten Transistors 7, hier ein Drain-Kontakt, mit dem ersten Anschlusskontakt 2a verbunden. Ein zweiter Schaltkontakt des zweiten Transistors 7, hier ein Source-Kontakt, ist mit dem zweiten Anschlusskontakt 2b verbunden.

Es ist somit ein erster Pol 3a des Energiespeichers 3 mit dem ersten Anschlusskontakt 2a gekoppelt. Dabei ist in dieser Ausführungsform der erste Pol 3a des Energiespeichers 3 direkt mit dem ersten Anschlusskontakt 2a verbunden. Der zweite Pol 3b des Energiespeichers ist mit dem zweiten Anschlusskontakt 2b gekoppelt. Dabei ist der zweite Pol 3b des Energiespeichers 3 über dem ersten Transistor 4 mit dem zweiten Anschlusskontakt 2b gekoppelt. Der erste Transistor 4 ist zwischen dem ersten Anschlusskontakt 2a und dem zweiten Anschlusskontakt 2b mit dem Energiespeicher 3 in Reihe geschaltet. Es ergibt sich somit eine Serienschaltung aus dem ersten Transistor 4 und dem Energiespeicher 3.

Die Steuerkontakte des ersten Transistors 4 und des zweiten Transistors 7 sind mit dem Steuerschaltkreis 6 verbunden. Dabei ist der Steuereingang des ersten Transistors 4 mit dem sechsten Anschluss 6f des Steuerschaltkreises 6 verbunden. Der Steuereingang des zweiten Transistors 7 ist mit dem zweiten Anschluss 6b des Steuerschaltkreises 6 verbunden. Der Steuerschaltkreis 6 ist dazu eingerichtet, einen Schaltvorgang des ersten Transistors 4 und einem Schaltvorgang des zweiten Transistors 7 zu steuern. Dies erfolgt dadurch, dass durch den Steuerschaltkreis 6 ein entsprechendes Signal an dem zweiten Anschluss 6b angelegt wird, um den zweiten Transistor 7 zu schalten bzw. dass durch den Steuerschaltkreis 6 ein entsprechendes Signal an dem sechsten Anschluss 6f angelegt wird, um den ersten Transistor 7 zu schalten.

Die Batteriezelle 1 umfasst ferner eine Sensorik 5, welche dazu eingerichtet ist, einen Zustandsparameter der Batteriezelle 1 zu erfassen. Die Sensorik 5 umfasst in dieser ersten Ausführungsform einen Spannungssensor 5a, einen Stromsensor 5b und einen Temperatursensor 5c. In anderen Ausführungsformen der Erfindung umfasst die Sensorik 5 nur eine Auswahl der hier genannten Sensoren. In dieser ersten Ausführungsform ist der Temperatursensor 5c in unmittelbarer Nähe des Energiespeichers 3 angeordnet, um eine Temperatur des Energiespeichers 3 zu erfassen. Der Temperatursensor 5c ist mit einem Anschlusskontakt an dem dritten Anschluss 6c und mit einem weiteren Anschlusskontakt an dem vierten Anschluss 6d des Steuerschaltkreises 6 angeschlossen. Die übrigen Komponenten der Sensorik 5 sind in dem Steuerschaltkreis 6 angeordnet. Dazu ist der erste Anschluss 6a des Steuerschaltkreises 6 mit dem ersten Anschlusskontakt 2a und dem ersten Pol 3a des Energiespeichers 3 verbunden. Ferner ist der siebte Anschluss 6g mit dem zweiten Anschlusskontakt 2b und somit mit dem zweiten Schaltkontakt des ersten Transistors 4 verbunden. Zudem ist der fünfte Anschluss 6e mit dem zweiten Pol 3b des Energiespeichers 3 und somit mit dem ersten Schaltkontakt des ersten Transistors 4 verbunden.

Der Steuerschaltkreis 6 ist dazu eingerichtet, einen Schaltvorgang des ersten Transistors 4 zu steuern, wobei der Steuerschaltkreis 6 den Transistor 4 basierend auf dem erfassten Zustandsparameter steuert, um einen Ladestrom oder einen Entladestrom des Energiespeichers 4 zu regeln. Das bedeutet, dass ein Stromfluss zu dem Energiespeicher 4 oder von dem Energiespeicher 4 geregelt wird. Dabei kann eine Größe des Stromflusses eingestellt werden. Diese Größe kann dynamisch eingestellt werden und kann dabei auf unterschiedliche Werte eingestellt werden. Der Steuerschaltkreis 6 ist somit nicht darauf beschränkt, einen Stromfluss von oder zu dem Energiespeicher 3 lediglich ein-und auszuschalten, sondern es können weitere Werte für eine Größe des fließenden Stromes eingestellt werden. Dazu ist in dem Steuerschaltkreis 6 ein Regelalgorithmus integriert. Die Sensorik 5, der Steuerschaltkreis 6 und der erste Transistor 4 bilden somit zusammen einen Regelkreis.

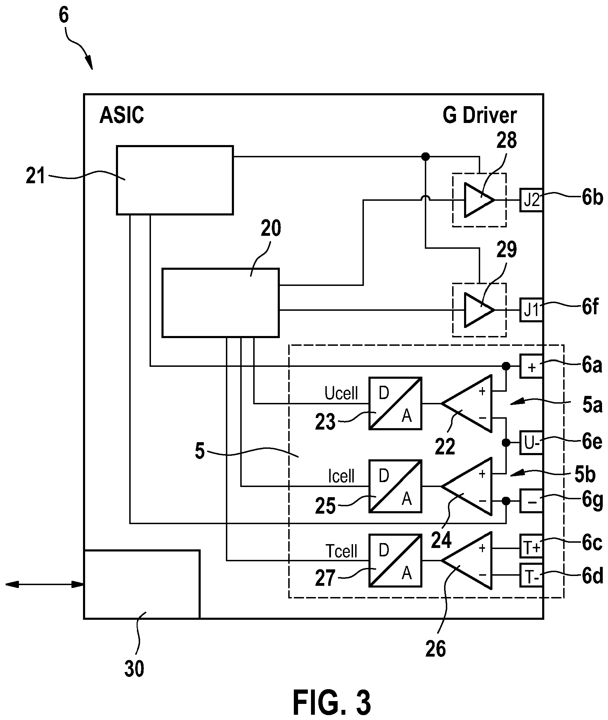

Figur 3 zeigt ein Schaltbild des Steuerschaltkreises 6 gemäß der ersten Ausführungsform der Erfindung. Der Steuerschaltkreis 6 umfasst eine Steuerlogik 20. Die Steuerlogik 20 ist dazu eingerichtet, Steuersignale an den zweiten Anschluss 6b und an den sechsten Anschluss 6f auszugeben, um den ersten Transistor 4 und den zweiten Transistor 7 anzusteuern. Dazu ist die Steuerlogik 20 über einen ersten Operationsverstärker 28 mit dem zweiten Anschluss 6b gekoppelt und ist über einen zweiten Operationsverstärker 29 mit dem sechsten Anschluss 6f gekoppelt. Sowohl die Operationsverstärker 28, 29 des Steuerschaltkreises 6 als auch die Steuerlogik 20 werden von einer Ladungspumpe 21 mit einer Versorgungspannung versorgt. Die Ladungspumpe 21 wird über den ersten Anschluss 6a und über den siebten Anschluss 6g mit einer Spannung versorgt, die von dem Energiespeicher 3 und/oder von weiteren in Reihe geschalteten Batteriezellen bereitgestellt wird, die mit dem ersten

Anschlusskontakt 2a und dem zweiten Anschlusskontakt 2b der Batteriezelle 1 verbunden sind.

Von der Sensorik 5 werden mehrere Zustandsparameter an die Steuerlogik 20 übertragen, die von der Sensorik 5 erfasst werden.

Die Sensorik 5 umfasst den Spannungssensor 5a. Der Spannungssensor 5a umfasst einen ersten Komparator 22, der mit einem ersten Eingangsanschluss mit dem ersten Anschluss 6a des Steuerschaltkreises 6 gekoppelt ist und mit einem zweiten Eingangsanschluss mit dem fünften Anschluss 6e des Steuerschaltkreises 6 verbunden ist. Es wird somit von dem ersten Komparator 22 ein Spannungsabfall über den Energiespeicher 3 erfasst. Ein Ausgangsanschluss des ersten Komparators 22 ist mit einem Eingang eines ersten Analog-zu-Digital-Wandlers 23 gekoppelt. Dieser erste Analog-zu-Digital-Wandler 23 setzt den Spannungsabfall in ein digitales Signal um. Dieses digitale Signal beschreibt die an dem Energiespeicher 3 anliegende Spannung, welche ein Zustandsparameter der Batteriezelle 1 ist. Ein Ausgangsanschluss des ersten Analog-zu-Digital-Wandler 23 ist mit einem Eingang der Steuerlogik 20 gekoppelt. Das digitale Ausgangssignal des ersten Anlag- zu Digitalwandlers 23 wird an die Steuerlogik 20 übertragen. Somit ist der Steuerlogik 20 der über dem Energiespeicher 3 vorliegende Spannungsabfall bekannt.

Ferner umfasst die Sensorik 5 den Stromsensor 5b. Der Stromsensor 5b umfasst einen zweiten Komparator 24, der mit einem ersten Eingangsanschluss mit dem fünften Anschluss 6e des Steuerschaltkreises 6 gekoppelt ist und mit einem zweiten Eingangsanschluss mit dem siebten Anschluss 6f des Steuerschaltkreises 6 verbunden ist. Es wird somit von dem zweiten Komparator 24 ein Spannungsabfall über den ersten Transistor 4 erfasst. Ein Ausgangsanschluss des zweiten Komparators 24 ist mit einem Eingang eines zweiten Analog-zu-Digital-Wandlers 25 gekoppelt. Dieser zweite Analog-zu-Digital-Wandler 25 setzt den Spannungsabfall in ein digitales Signal um. Dieses digitale Signal beschreibt die über den ersten Transistor 4 anliegende Spannung. Ein Ausgangsanschluss des zweiten Analog-zu-Digital-Wandler 25 ist mit einem Eingang der Steuerlogik 20 gekoppelt. Das digitale Ausgangssignal des zweiten Anlag- zu Digitalwandlers 25 wird an die Steuerlogik 20 übertragen. Da der erste Transistor 4 durch die Steuerlogik 20 angesteuert wird, ist der Steuerlogik 20 ferner ein jeweils vorliegender Widerstandswert des ersten Transistors 4 bekannt. Basierend auf dem vorliegender Widerstandswert des ersten Transistors 4 und dem von dem zweiten Analog-zu-Digital-Wandler 25 bereitgestellten digitalen Signal ermittelt die Steuerlogik 20 den durch die Batteriezelle 1 fließenden Strom.

Die Sensorik 5 umfasst ferner den Temperatursensor 5c. Der Temperatursensor 5c ist mit dem dritten Anschluss 6c und dem vierten Anschluss 6d des Steuerschaltkreises 6 verbunden. In dem Steuerschaltkreis 6 ist ein dritter Komparator 26 mit einem ersten Eingangsanschluss mit dem dritten Anschluss 6c und mit einem zweiten Eingangsanschluss mit dem vierten Anschluss 6d des Steuerschaltkreises 6 verbunden. Ein Spannungsabfall über den Temperatursensor 5c beschreibt eine Temperatur des Energiespeichers 3. Ein Ausgang des dritten Komparators 26 ist mit einem Eingang eines dritten Analog-zu Digitalwandler 27 gekoppelt. Dieser dritte Analog-zu-Digital-Wandler 27 setzt die Spannung, welche die Temperatur beschreibt, in ein digitales Signal um. Ein Ausgangsanschluss des dritten Analog-zu-Digital-Wandler 27 ist mit einem Eingang der Steuerlogik 20 gekoppelt. Das digitale Ausgangssignal des dritten Anlag- zu Digitalwandlers 27 wird an die Steuerlogik 20 übertragen. Die Steuerlogik 20 setzt das digitale Signal in einen Temperaturwert um.

Der Steuerlogik 20 und somit dem Steuerschaltkreis 6 stehen somit Messwerte für den zu oder von dem Energiespeicher 3 fließender Strom, die über den Energiespeichers 3 anliegende Spannung und die Temperatur des Energiespeichers 3 als Eingangsvariablen zur Verfügung.

Optional umfasst der Steuerschaltkreis 6 eine externe Schnittstelle 30, welche mit benachbarten Batteriezellen 1 oder einem Batteriemanagementsystem gekoppelt ist und welche dazu geeignet ist, Steuersignale zu empfangen und/oder Messwerte zu senden. So können einzelne Aktionen des Steuerschaltkreises 6, insbesondere ein Cell-Balancing, über die externe Schnittstelle 30 ausgelöst werden.

Durch den Steuerschaltkreis 6 wird ein Schaltvorgang des ersten Transistors 4 so gesteuert, dass basierend auf dem erfassten Zustandsparameter ein Ladestrom oder ein Entladestrom des Energiespeichers 4 geregelt wird. Ob der fließende Strom dabei ein Ladestrom oder ein Entladestrom des Energiespeichers 4 ist, hängt dabei davon ab, welche Spannung an den ersten Anschlusskontakt 2a und dem zweiten Anschlusskontakt 2b anliegt.

Der erste Transistor 4 wird entweder durch ein pulsweitenmoduliertes Signal angesteuert oder in einem Widerstandsbetrieb betrieben.

Wird der erste Transistor 4 durch das pulsweitenmodulierte Signal angesteuert, so wird der erste Transistor 4 wechselweise in einen offenen und in einen geschlossenen Zustand, also in einen hochohmigen und in einen niederohmigen Zustand, geschaltet. Abhängig von einer Pulsweite und/oder Frequenz des pulsweiten modulierten Signals, welches an dem sechsten Anschluss 6f des Steuerschaltkreises 6 von der Steuerlogik 20 bereitgestellt wird, kann somit ein Stromfluss durch den Energiespeicher 4 geregelt werden.

Alternativ wird der erste Transistor 4 in dem Widerstandsbetrieb betrieben. Das bedeutet, dass der erste Transistor 3 als ein regelbarer Widerstand genutzt wird. Dies erfolgt dadurch, dass über den sechsten Anschluss 6f Steuerschaltkreises 6 von der Steuerlogik 20 ein analoges Signal an den Steuereingang des ersten Transistors 4 angelegt wird.

In unterschiedlichen Ausführungsformen ist der Steuerschaltkreis 6 entweder dazu eingerichtet, nur ein gepulstes Signal an den ersten Transistor 4 auszugeben, nur ein analoges Steuersignal an den ersten Transistor 4 auszugeben oder wahlweise ein gepulstes Signal oder ein analoges Steuersignal an den ersten Transistor 4 auszugeben.

Bei dem prinzipiellen Aufbau der in den Figuren 1 und 3 beschriebenen Ausführungsform umfasst die Batteriezelle 1 einen Energiespeicher 3, einen Serien-Schalter (den ersten Transistor 4, z.B. MOSFET) und einen Parallel-bzw. Kurzschluss-Schalter (den zweiten Transistor 7, z.B. MOSFET), einem ASIC, Sensoren (beispielsweise einem Temperatur-Sensor) und einer (optionalen) Schnittstelle des ASICs nach außen. Trotz Integration von Schaltern, Sensorik und Logik wirkt die einzelne Batteriezelle nach außen hin wieder wie ein (nun aktiver) Zweipol und lässt sich z.B. in Batterie-Blöcken und Modulen zur Leistungs-bzw. Spannungserhöhung verbauen. Die verbauten MOSFETs sind vorzugsweise Niedervolt NMOS Transistoren, können aber auch durch PMOS oder Bipolare Bauelemente realisiert sein. Ferner kann der Serien-MOSFET in Serie an Plus-oder Minus-Pol der Batterie angeschlossen sein.

Der Temperatursensor 5c ist nahe dem Energiespeicher 3 verbaut zur Erfassung der aktuellen Temperatur. Der ASIC schöpft seine Stromversorgung direkt aus der beschalteten Batterie, stellt Gatesignale (Gate Treiber) für die MOSFETs bereit, überwacht mittels A/D Kanälen Zelltemperatur und Zellspannung sowie den Zellstrom anhand des proportionalen Spannungsabfalles am Serientransistor (dem ersten Transistor 4) bei bekannten Widerstand des voll aufgesteuerten ersten Transistors 4. Über ein (optionales) Interface kann der ASIC Steuersignale erhalten und Zustandsmeldungen abgeben. Das Interface kann entweder über zusätzliche Steuerleitungen erfolgen oder über Aufmodulation von Steuerbefehlen auf die Zellterminals, also über die Anschlusskontakte 2a, 2b erfolgen. Jedes ASIC kann zudem non-volatile Informationen über die jeweilige Batteriezelle enthalten (Status, Lage, Fehlerflag, ...).

Figur 2 zeigt eine Batteriezelle 1 gemäß einer zweiten Ausführungsform der Erfindung. Die zweite Ausführungsform der Erfindung entspricht der ersten Ausführungsform der Erfindung, wobei der erste Transistor 4 mit dem ersten Anschlusskontakt 2a verbunden ist und der Energiespeicher 3 mit dem zweiten Anschlusskontakt 2b verbunden ist. Der Energiespeicher 3 und der erste Transistor 4 sind somit weiterhin in Serie geschaltet, wobei deren Position gegenüber der ersten Ausführungsform der Erfindung vertauscht ist.

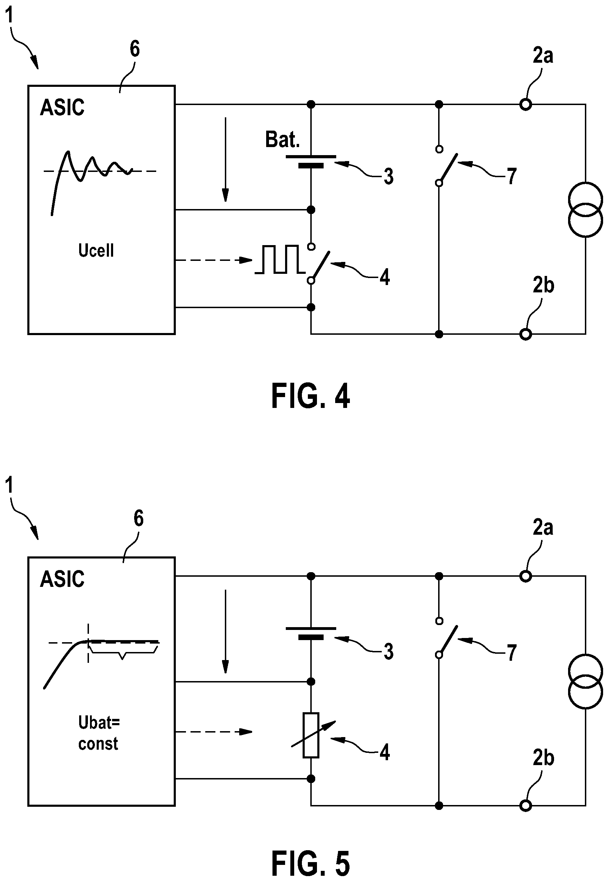

Die Funktion des mit der Batteriezelle 1 geschaffenen integrierten intelligenten Batterie Schalters bezieht sich auf eine Vielzahl von Einsatzbereichen der Batteriezelle 1, wie optimiertes Laden, Entladen (Betrieb), Sicherstellen des Betriebes in einem optimalen Arbeitspunkt, Diagnose von SoC, SoH und SoF, Sicherheitsfunktionen sowie der Bereitstellung eines sicheren Zustandes bei Wartungsarbeiten. Der Ladestrom und/oder der Entladestrom des Energiespeichers 4 werden dazu in entsprechender Weise basierend auf dem Zustandsparameter der Batteriezelle 1 gesteuert. Dabei kann das Steuern des ersten Transistors 4 auf unterschiedliche Weise und zu unterschiedlichen Zwecken erfolgen. Vorteilhafte Beispiele für das Ansteuern des ersten Transistors 4 werden im Folgenden, insbesondere mit Bezug auf die Figuren 4, 5, 6, 7, 8 und 9, im Detail beschrieben.

Figur 4 zeigt einen beispielhaften ersten Betriebsmodus der Batteriezelle 1. Der erste Betriebsmodus ist eine Laderegelung, wobei ein Ladestrom des Energiespeichers 4 durch den ersten Transistor 4 und die entsprechende Ansteuerung durch den Steuerschaltkreis 6 geregelt wird. In dem Steuerschaltkreis 6, insbesondere in der Steuerlogik 20, ist ein Zielspannungswert hinterlegt, der eine Ausgangsspannung des Energiespeichers 3 in einem geladenen Zustand beschreibt. Die tatsächliche Ausgangsspannung des Energiespeichers 3 wird durch die Sensorik 5 erfasst. Es erfolgt nunmehr ein gepulstes Laden des Energiespeichers 3, wobei der erste Transistor 4 durch das pulsweitenmodulierte Signal wechselweise in einen hochohmigen und in einen niederohmigen Zustand geschaltet wird. Ist der erste Transistor 4 in einen hochohmigen Widerstand geschaltet, so wird durch die Sensorik 5 die Ausgangsspannung des Energiespeichers 3 erfasst. Liegt diese unterhalb des Zielwertes, so wird der Ladevorgang fortgesetzt, also das pulsweitenmodulierte Signal weiterhin an den ersten Transistor 4 angelegt. Dies erfolgt solange, bis der Energiespeicher 3 die als Zielwert angegebene Ausgangsspannung abgibt und dies von der Sensorik 5 erfasst wird. In dem ersten Modus ist der zweite Transistor 7 in einen hochohmigen Zustand geschaltet, das bedeutet, dass der durch den zweiten Transistor 7 gebildete Schalter offen ist.

Figur 4 zeigt somit die Verwendung des ersten Transistors 4 als Schalter bei einem gepulsten Ladebetrieb. Hierbei wird die Batteriespannung (und ggf. der Batterie-Innenwiderstand) überwacht und der Ladestrom gepulst über den ersten Transistors 4 auf den Energiespeicher 3 geschaltet. Vorteilhaft ist, dass in diesem Betrieb ein schnelleres Laden ermöglich wird. Zudem ist sichergestellt, dass der (einzelne) Energiespeicher 3 nicht überladen wird.

Mittels des ersten Transistors 4 kann zudem aus diesem Grund eine Spannungsbegrenzung auf Zell-Ebene realisiert werden, in dem der erste Transistor 4 in Widerstandsbetrieb betrieben wird. Dies ist in Figur 5 dargestellt. Figur 5 beschreibt einen zweiten Betriebsmodus, welcher ein Lademodus der Batteriezelle 1 ist. Der zweite Betriebsmodus entspricht im Wesentlichen dem ersten Betriebsmodus, wobei der erste Transistor im Widerstandsbetrieb betrieben wird, das bedeutet, dass ein durch den ersten Transistor 4 bereitgestellter Widerstandswert so eingestellt wird, dass die erfasste Spannung über den Energiespeicher 3 sich einem Zielwert annähert.

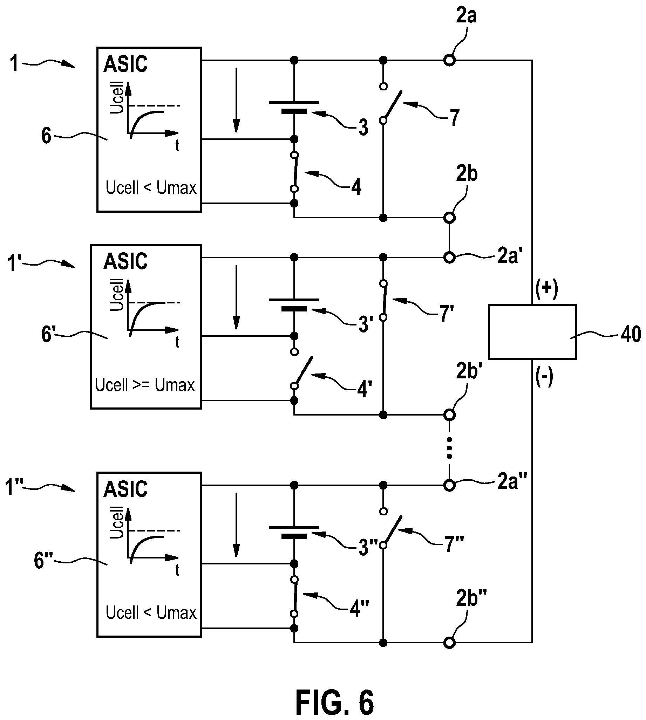

Sowohl der erste Betriebsmodus als auch der zweite Betriebsmodus können für ein aktives Cell-Balancing eingesetzt werden. Dabei wird der Energiespeicher 3 entweder durch das gepulste Schließen des ersten Transistors 4 oder das Regeln des ersten Transistors 4 auf einen bestimmten Widerstandswert entweder geladen oder entladen. Hat die Spannung des Energiespeichers 3 einen bestimmten Zielwert erreicht, so wird der erste Transistor 4 in einen hochohmigen Zustand geschaltet und der zweite Transistor 7 wird in einen niederohmigen Zustand geschaltet, um den Energiespeicher 3 zu überbrücken. Dies ermöglicht, dass benachbarte Batteriezellen der Batteriezelle 1 das Cell-Balancing weiterführen können. Es wird dazu auf Figur 6 verwiesen.

Ebenfalls vorteilhaft ist der Einsatz der Batteriezelle im Ladebetrieb zum (aktiven) Balancing. Da die einzelnen Zellen einer Batterie in der Applikation zu Blöcken verschaltet sind (z.B. Serienschaltung zur Erhöhung der Spannung) sind die einzelnen Batteriezellen i.d.R. nicht einzeln der Lade-Elektronik zugänglich. Mittels der Batteriezelle 1 ist jedoch eine Überwachung des Ladezustandes und der (maximal erlaubten) End-Spannung möglich. Mittels des ersten Transistors 4 können sich bereits vollgeladene Batteriezellen aus der Serienschaltung herauskoppeln. Der zweite Transistor 7 stellt dabei die Überbrückung/ Aufrechterhaltung der verbleibenden Serienschaltung sicher. Dies ist ferner mit Figur 6 dargestellt.

Figur 6 zeigt eine beispielhafte Batterie, welche eine Serienschaltung von drei Batteriezellen umfasst, wobei jede der Batteriezellen eine der erfindungsgemäßen Batteriezellen 1 ist. So umfasst die in Figur 6 gezeigte Batteriezelle 1 eine erste Batteriezelle 1, eine zweite Batteriezelle 1' und eine dritte Batteriezelle 1".

An die Batterie ist ein Ladegerät 40 angeschlossen, welches eine Gleichspannung als Ladespannung bereitstellt. In jeder der Batteriezellen 1,1', 1" der Batterie wird durch die jeweilige Sensorik 5, 5', 5" der Batteriezelle 1,1', 1" ein Spannungsabfall über den zugehörigen Energiespeicher 3, 3', 3" erfasst und der jeweilige erste Transistor 4, 4', 4" wird entsprechend geschaltet, um eine Ausgangsspannung Ucell des Energiespeichers 3 auf einen vorgegebenen Zielwert Umax zu regeln.

So ist in dem in Figur 6 gezeigten Zustand eine Ausgangsspannung des Energiespeichers 3 der ersten Batteriezelle 1 und die Ausgangsspannung des Energiespeichers 3" der dritten Batteriezelle 1" geringer als der Zielwert Umax. Der erste Transistor 4, 4" der jeweiligen Batteriezelle 1, 1" ist daher in einem niederohmigen Zustand. Der Energiespeicher 3' der zweiten Batteriezelle 1' hat den Zielwert Umax bereits erreicht. Daher ist der erste Transistor 4' der zweiten Batteriezelle 1' in einen hochohmigen Zustand geschaltet. Der zweite Transistor 7' der zweiten Batteriezelle 1" ist in einen niederohmigen Zustand geschaltet, um die zweite Batteriezelle 1' zu überbrücken. Der zweite Transistor 7' der ersten und dritten Batteriezelle 1, 1" ist in einen hochohmigen Zustand geschaltet, um ein weiteres Laden der Energiespeicher 3, 3" der ersten und der dritten Batteriezelle 1, 1" zu ermöglichen.

Der Steuerschaltkreis 6 ist somit dazu eingerichtet, den Schaltvorgang des ersten Transistors 3 zum Regeln des Ladestroms oder des Entladestroms so anzusteuern, dass ein Cell-Balancing ausgeführt wird.

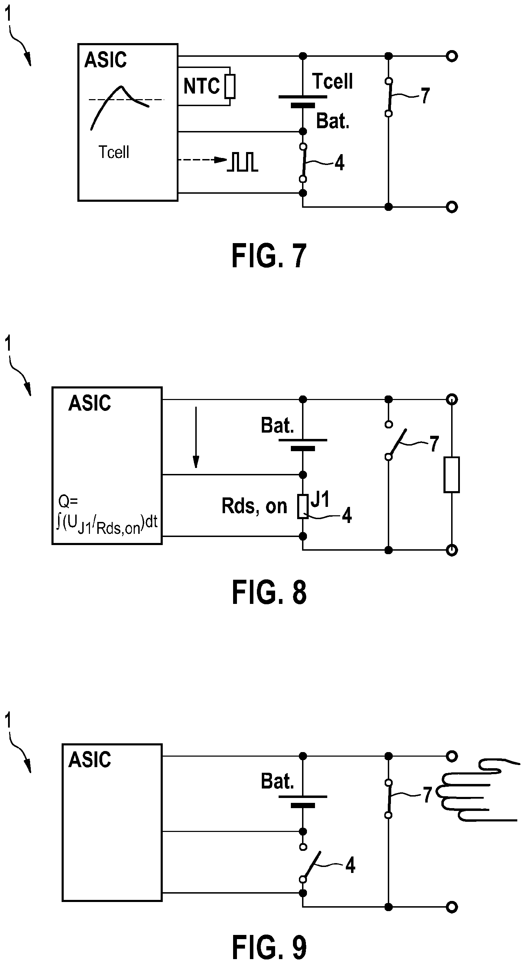

Figur 7 zeigt einen dritten beispielhaften Betriebsmodus der Batteriezelle 1. In dem dritten Betriebsmodus wird sowohl der erste Transistor 4 als auch der zweite Transistor 7 in einen niederohmigen Zustand geschaltet. Der erste Transistor 4 wird dabei entweder durch das pulsweitenmodulierte Signal angesteuert oder im Widerstandsbetrieb betrieben. Die Batteriezelle 1, insbesondere der Energiespeicher 3, erwärmt sich bei einer solchen Schaltung des ersten Transistors 4 und des zweiten Transistors 7, da der Energiespeicher 3 über den ersten Transistor 4 und den zweiten Transistor 7 entladen wird. Da die Temperatur des Energiespeichers 3 von der Sensorik 5 erfasst wird, erfolgt eine Regelung durch den Steuerschaltkreis 6. Dabei wird die von der Sensorik 5 ermittelte aktuelle Temperatur des Energiespeichers 3 mit einem Vergleichswert verglichen und der erste Transistor 4 wird entsprechend in einen niederohmigen Zustand geschaltet, bis der Energiespeicher 3 den Temperaturzielwert erreicht hat.

Alternativ wird in dem dritten Betriebsmodus der erste Transistor 3 und der zweite Transistor 7 gleichzeitig in einen niederohmigen Zustand geschaltet, um den Energiespeicher 3 gezielt zu entladen. In einer solchen Ausführung des dritten Betriebsmodus kann der Energiespeicher 3 beispielsweise in einen sicheren Betriebszustand entladen werden, falls beispielsweise eine äußere Beschädigung der Batteriezelle 1 festgestellt wurde, was entweder durch die Sensorik 5 erfolgt oder durch die externe Schnittstelle 30 als Steuerbefehl der Batteriezelle 1 bereitgestellt wird.

Figur 7 zeigt somit eine Möglichkeit bei der beide Transistoren 4, 7 (zeitweise) geschlossen werden. Dieser "Kurzschlussbetrieb" kann verwendet werden, um den Energiespeicher 3 durch Verluste am Innenwiderstand und den thermisch mit dem Energiespeicher 3 gekoppelten MOSFETs "vorzuheizen" und auf optimale Betriebstemperatur zu bringen. Ferner kann diese Betriebsart genutzt werden um eine "Schnellentladung" der Zelle z.B. bei äußerer Beschädigung und der Gefahr eines thermisch instabilen Zustandes zu bewirken und in einen sicheren Zustand zu fahren.

Figur 8 zeigt einen vierten Betriebsmodus der Batteriezelle 1. In dem vierten Betriebsmodus wird ein Ladezustand des Energiespeichers 3, ein Alterungszustand des Energiespeichers 3 und/oder ein Funktionszustand des Energiespeichers 3 ermittelt. Dies erfolgt bevorzugt in einem Servicemodus, welcher durch die externe Schnittstelle 30 ausgelöst wird. In dem Servicemodus wird eine vordefinierte Last an die der Batteriezelle 1 zugehörige Batterie angeschlossen. Der erste Transistor 4 wird auf einen vorgegebenen Widerstandwert geregelt. Der Energiespeicher 3 entlädt sich somit über den ersten Transistor 4, wobei dem Steuerschaltkreis 6 der Widerstandswert des ersten Transistors 4 bekannt ist. Gleichzeitig ist dem Steuerschaltkreis 6 durch die Sensorik 5 die Ausgangsspannung des Energiespeichers 3 bekannt. Aus diesen Werten wird ermittelt, welche Ladung von dem Energiespeicher 3 über eine vordefinierte Zeit hinweg abgegeben wird. Aus diesen Werten wird der aktuelle Ladezustand des Energiespeichers, dessen Alterungszustand und dessen Funktionszustand ermittelt. Diese Werte werden bevorzugt in dem Steuerschaltkreis 6 gespeichert und für ein späteres Regeln des Ladestroms oder des Entladestroms des Energiespeichers 4 herangezogen. Alternativ oder zusätzlich werden die so ermittelten Werte bezüglich des Ladezustands des Energiespeichers, des Alterungszustands des Energiespeichers 3 und/oder des Funktionszustandes des Energiespeichers 3 über die externe Schnittstelle 30 an ein Batteriemanagementsystem übermittelt. Der zweite Transistor 7 ist in dem vierten Betriebsmodus in einem hochohmigen Zustand, und der durch den zweiten Transistor 7 gebildete Schalter ist somit offen.

Figur 8 zeigt somit den Betrieb der Batteriezelle 1 zur Ermittlung des SoC (State of Charge oder Ladezustand) als Coulomb Counter, in welchem der (indirekt über dem ersten Transistor 4 bestimmte Entladestrom auf integriert wird.

Figur 9 zeigt einen fünften Betriebsmodus der Batteriezelle 1. Dieser Betriebsmodus kann auch als Wartungsmodus bezeichnet werden. In dem Wartungsmodus wird lediglich der zweite Transistor 4 in einen niederohmigen Zustand geschaltet und der erste Transistor 4 wird in einen hochohmigen Zustand geschaltet. Der Energiespeicher 3 wird somit überbrückt. Der Wartungsmodus kann entweder über die externe Schnittstelle 30 ausgelöst werden oder kann ausgelöst werden, wenn die Batteriezelle 1, also der Steuerschaltkreis 6 der Batteriezelle 1, feststellt, dass der Ladezustand des Energiespeichers 3, der Alterungszustand des Energiespeichers und/oder der Funktionszustand des Energiespeichers 3 einen regulären Betrieb der Batteriezelle 1 nicht weiter zulässt. Dies weist unter anderem den Vorteil auf, dass die Batteriezelle 1 während einer Wartung an den Anschlusskontakten 2a, 2b gefahrlos berührt werden kann und dass die Batteriezelle 1 aus einer Serien-oder Parallelschaltung mehrerer Batteriezellen ausgeschlossen wird, um eine weitere Beschädigung des Energiespeichers 3 oder ein thermisches Durchgehen der Batteriezelle 1 zu vermeiden.

In dem Wartungsmodus kann somit eine Spannungsfreiheit der Batteriezelle 1 und somit der Batterie sichergestellt werden indem alle Batteriezellen dekontaktiert werden. Zudem können besonders schwache Blöcke bis hin zu Einzelzellen ausgetauscht werden, i.d.R. die Batteriezellen mit dem niedrigsten SoH, so dass die Lebensdauer der gesamten Batterie entsprechend verlängert werden kann.

Weitere Einsatzmöglichkeiten des Batterie-Schalters im Lade-Entlade-Betrieb, zur Diagnose und Austausch sind denkbar und nicht auf die o.g. Funktionen beschränkt.

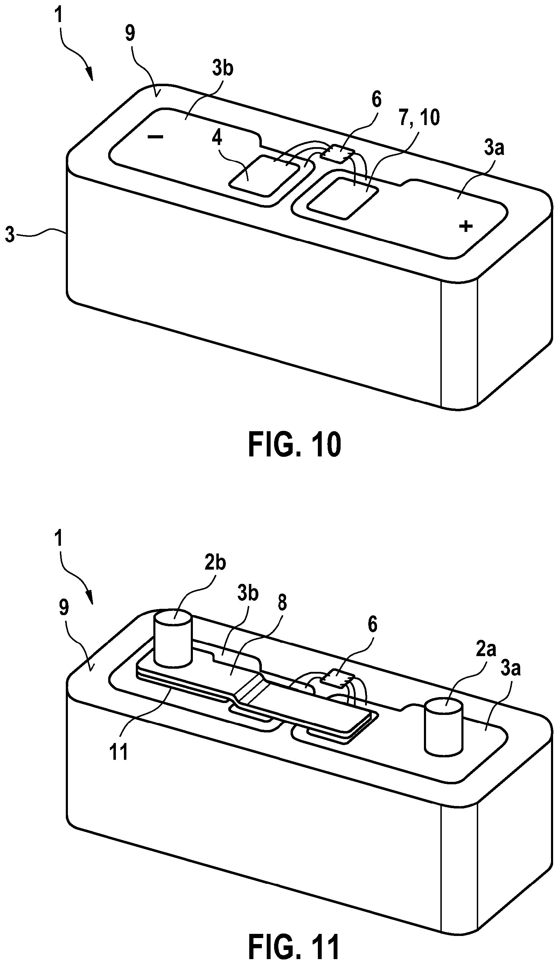

Figur 10 beschreibt einen vorteilhaften Aufbau der Batteriezelle 1. Die Batteriezelle 1 ist dabei eine prismatische Batteriezelle. Der Energiespeicher 3 ist dabei eine Einheit, welche zumindest eine äußere Oberfläche 9 aufweist, welche einen ersten Bereich umfasst, die den ersten Pol 3a bildet und einen zweiten Bereich umfasst, der den zweiten Pol 3b bildet. Auf dem ersten Pol 3a ist ein weiterer Transistor 10 angeordnet, welcher der zweite Transistor 7 ist. Auf dem zweiten Pol 3b ist der erste Transistor 4 angeordnet. Der erste Transistor 4 und der zweite Transistor 7 liegen dabei flächig auf dem jeweiligen Pol 3a, 3b auf.

Der erste Transistor 4 ist somit auf einer äußeren Oberfläche 9 des Energiespeichers 3 angeordnet.

Eine erste Kontaktoberfläche des ersten Transistors 4 liegt auf dem zweiten Pol 3b des Energiespeichers auf. Dabei bildet die erste Kontaktoberfläche des ersten Transistors 4 den ersten Schaltkontakt des ersten Transistors 4. In entsprechender Weise liegt der zweite Transistor 7 auf dem ersten Pol 3a des Energiespeichers 3 auf. Dabei ist der zweite Transistor 7 so auf der äußeren Oberfläche 9 des Energiespeichers 3 angeordnet, dass eine erste Kontaktfläche des zweiten Transistors 7 auf dem ersten Pol 3a des Energiespeichers 3 aufliegt. Die erste Kontaktfläche des zweiten Transistors 7 entspricht dem ersten Schaltkontakt.

Bei einem entsprechenden Durchschalten des ersten Transistors 4 oder des zweiten Transistors 7 kann somit die von dem Energiespeicher 3 bereitgestellte Spannung an der in Figur 10 oben liegenden Oberfläche des ersten Transistors 4 und des zweiten Transistors 7 bereitgestellt werden. Der Steuerschaltkreis 6 ist auf derselben obenliegenden Oberfläche 9 des Energiespeichers 3 angeordnet. Der Steuerschaltkreis 6 ist dabei entsprechend den in Figur 1 und Figur 2 dargestellten Ausführungsformen mit dem ersten Transistor 4, dem zweiten Transistor 7, dem ersten Pol 3a und dem zweiten Pol 3b gekoppelt.

Figur 11 zeigt die aus Figur 10 bekannte Batteriezelle 1 in einem betriebsbereiten Zustand. Dabei ist auf dem ersten Pol 3a der erste Anschlusskontakt 2a angeordnet, wobei der erste Pol 3a mit dem ersten Anschlusskontakt 2a elektrisch leitfähig verbunden ist. Dieser erste Anschlusskontakt 2a ermöglicht es, die Batteriezelle 1 zu kontaktieren. Auf dem ersten Transistor 4 und dem zweiten Transistor 7 ist ein plattenförmiger Leiter 8 angeordnet. Der plattenförmige Leiter 8 liegt auf einer zweiten Kontaktfläche des ersten Transistors 4 auf, welche der äußeren Oberfläche 9 des Energiespeichers 3 abgewandt ist. Die zweite Kontaktfläche des ersten Transistors 4 bildet dabei den zweiten Schaltkontakt des ersten Transistors 4. Der plattenförmige Leiter 8 liegt ferner auf einer zweiten Kontaktfläche des zweiten Transistors 7 auf, welche der äußeren Oberfläche 9 des Energiespeichers 3 abgewandt ist. Die zweite Kontaktfläche des ersten Transistors 4 bildet dabei den zweiten Schaltkontakt des zweiten Transistors 7. Es besteht somit eine elektrische Verbindung zwischen dem plattenförmigen Leiter 8 und dem ersten Pol 3a über den zweiten Transistor 7, wenn dieser in einen niederohmigen Zustand geschaltet ist.

Der plattenförmige Leiter 8 ist durch ein zwischenliegendes isolierendes Element 11 von dem zweiten Pol 3b isoliert. Jedoch kann eine elektrische Verbindung zwischen dem plattenförmigen Leiter 8 und dem zweiten Pol 3b hergestellt werden, wenn der erste Transistor 4 in einen leitenden Zustand geschaltet wird. Auf dem plattenförmigen Leiter 8 ist der zweite Anschlusskontakt 2b angeordnet. Es wird somit die aus Figur 1 bekannte Schaltung realisiert.

So wird beispielsweise dann, wenn der zweite Transistor 7 in einen niederohmigen Zustand geschaltet wird, eine direkte Verbindung zwischen dem ersten Anschlusskontakt 2a und dem zweiten Anschlusskontakt 2b hergestellt. Wird der zweite Transistor 7 in einen hochohmigen Zustand geschaltet, so erfolgt ein Stromfluss über den zweiten Anschlusskontakt 2b durch den ersten Transistor 4 durch den Energiespeicher 3 hindurch zu dem ersten Anschlusskontakt 2a.

In den Figuren 10 und 11 ist ein Ausführungsbeispiel für eine prismatische Zelle dargestellt. Dabei werden die Transistoren 4, 7 als Bare-Dies direkt auf die metallischen Kontaktflächen der Zelle aufgebracht (z.B. Löten, Kleben, Sintern). Der ASIC ist ebenfalls direkt auf der Zelle platziert und kontaktiert die MOSFETs (z.B. über Bondverbindungen). Der Temperatursensor 5c ist vorzugsweise auf dem ASIC mit integriert. Ein Kupfer-Clip kontaktiert beide MOSFETs und stellt den äußeren Kontakt, bevorzugt einen negativen Pol, dar. Das Ausführungsbeispiel zeigt den geringen benötigten Bauraum und den einfachen Aufbau des integrierten Batterie Schalters. Vergleichbare Integration in zylindrische und Pouch-Zellen sind ebenfalls vorteilhaft.

Die beschriebenen Ausführungsformen offenbaren eine elektronische Verschaltung der Transistoren 4, 7, der Batteriezelle 1 und einem applikationsspezifischen integrierten Schaltkreis zur direkten Ansteuerung der Transistoren 4, 7. Zusätzliche Sensoren (z.B. Temperatur-Sensor, Überwachung von Zellstrom-und Spannung) sind zur Detektion des Zell-Status der Batteriezelle 1 geeignet. Diese Verschaltung realisiert zahlreiche elektrische Funktionen auf Zell-Ebene autonom ohne Eingriff einer übergeordneten Regeln (z.B. BMS). Erfindungsgemäß wird somit erreicht, dass genaue und zell-feine Informationen zum Zustand jeder einzelnen Batteriezelle (SoC, SoH, SoF) verfügbar sind. Zudem kann ein optimaler, individueller Betrieb jeder einzelnen Batteriezelle im optimalen Arbeitspunkt in Abhängigkeit von SoC, SoH, SoF, Temperatur, Leistungsanforderung, etc. im Lade-, Entlade-Betrieb erfolgen. Einige der o.g. Funktionen (Balancing, Sicherheitsschaltung, PulsedCharing, ...) lassen sich nur mit einzelnen Schaltern für jede Batteriezelle realisieren. In anderen Fällen reduziert der integrierte Schalter die Komplexität/ Overhead äußerer Regelungen und Elektronik (z.B. des Batterie Management Systems BMS). Es wird somit eine Lösung zur zellfeinen "Regelung" von Abgabe und Aufnahme von Ladung in Abhängigkeit von SoC, SoH, SoF, Zykelzahl, Temperatur, Zellimpedanz, etc. ermöglicht. Damit wird die Möglichkeit einer signifikant verbesserten Zykelfestigkeit (durch Betrieb im optimalen Arbeitspunkt) und Reichweite (durch optimale Ausnutzung der vorhandenen Kapazität und optimale Ladung) erreicht. Damit kann der Einsatz des durch die Batteriezelle 1 geschaffenen integrierten Batterieschalters bei gleichbleibender Batterie eine Erhöhung der Reichweite und der Verlängerung der Lebensdauer eines E-Fahrzeuges bewirken. Zudem erfolgt eine Realisierung elektronischer Sicherheit jede einzelner Batteriezelle inklusive einer Schnellentlade-Funktion.

Nebst offenstehender Offenbarung wird explizit auf die Offenbarung der Figuren 1 bis 11 verwiesen.

## Patentansprüche

1. Batteriezelle (1), umfassend:
- einen ersten Anschlusskontakt (2a) und einen zweiten Anschlusskontakt (2b),
- einen Energiespeicher (3),
- einen ersten Transistor (4),
- eine Sensorik (5), welche dazu eingerichtet ist, einen Zustandsparameter der Batteriezelle (1) zu erfassen, und
- einen Steuerschaltkreis (6),
- wobei ein erster Pol (3a) des Energiespeichers mit dem ersten Anschlusskontakt (2a) gekoppelt ist und ein zweiter Pol (3b) des Energiespeichers (3) mit dem zweiten Anschlusskontakt (2b) gekoppelt ist,
- wobei der erste Transistor (4) zwischen dem ersten Anschlusskontakt (2a) und dem zweiten Anschlusskontakt (2b) mit dem Energiespeicher (3) in Reihe geschaltet ist, und
- wobei der Steuerschaltkreis (6) dazu eingerichtet ist, einen Schaltvorgang des ersten Transistors (4) zu steuern, wobei der Steuerschaltkreis (6) den ersten Transistor (4) basierend auf dem erfassten Zustandsparameter steuert, um einen Ladestrom oder einen Entladestrom des Energiespeichers (4) zu regeln,
- einen zweiten Transistor (7), welcher zwischen dem ersten (2a) Anschlusskontakt und dem zweiten Anschlusskontakt (2b) parallel zu dem Energiespeicher (3) geschaltet ist,
- wobei der Steuerschaltkreis (6) dazu eingerichtet ist, einen Schaltvorgang des zweiten Transistors zu (7) steuern,
- wobei der zweite Transistor (7) insbesondere ein Dünnfilm-MOSFET Transistor ist, **dadurch gekennzeichnet, dass** der Steuerschaltkreis (6) dazu eingerichtet ist, sowohl den ersten Transistor (3) als auch den zweiten Transistor (7) gleichzeitig in einen leitenden Zustand zu schalten, um die Batteriezelle zu beheizen.

2. Batteriezelle (1) gemäß Anspruch 1, wobei die Sensorik (5) zumindest eines aus einem Spannungssensor (5a), einem Stromsensor (5b) und einem Temperatursensor (5c) umfasst.

3. Batteriezelle (1) gemäß einem der vorherigen Ansprüche, wobei der erste Transistor (3) ein Dünnfilm-MOSFET Transistor ist.

4. Batteriezelle (1) gemäß einem der vorherigen Ansprüche, wobei der Steuerschaltkreis (6) dazu eingerichtet ist, den Schaltvorgang des ersten Transistors (3) zum Regeln des Ladestroms oder des Entladestroms durch ein gepulstes Schalten des ersten Transistors (3) oder durch ein Betreiben des ersten Transistors (3) in einem Widerstandsbetrieb zu regeln.

5. Batteriezelle (1) gemäß einem der vorherigen Ansprüche, wobei der Steuerschaltkreis (6) dazu eingerichtet ist, den Schaltvorgang des ersten Transistors (3) zum Regeln des Ladestroms oder des Entladestroms so anzusteuern, dass ein Cell-Balancing ausgeführt wird.

6. Batteriezelle (1) gemäß einem der vorherigen Ansprüche, wobei der Steuerschaltkreis (6) dazu eingerichtet ist, einen Ladezustand des Energiespeichers (3), einen Alterungszustand des Energiespeichers (3) und/oder einen Funktionszustand des Energiespeichers (3) zu ermitteln.

7. Batteriezelle (1) gemäß einem der vorherigen Ansprüche,
- wobei der erste Transistor (4) auf einer äußeren Oberfläche (9) des Energiespeichers (3) angeordnet ist, wobei eine erste Kontaktoberfläche des ersten Transistors (4) auf dem zweiten Pol (3b) des Energiespeichers (3) aufliegt,
- wobei ein plattenförmigen Leiter (8) auf einer zweiten Kontaktoberfläche des ersten Transistors (4) aufliegt, welche der äußeren Oberfläche (9) des Energiespeichers (3) abgewandt ist, und
- wobei der plattenförmige Leiter (8) mit dem zweiten Anschlusskontakt (2b) elektrisch verbunden ist.

8. Batteriezelle (1) gemäß Anspruch 7,
- wobei ein weiterer Transistor (10) auf der äußeren Oberfläche (9) des Energiespeichers (3) angeordnet ist, wobei eine erste Kontaktoberfläche des weiteren Transistors (4) auf dem ersten Pol (3a) des Energiespeichers (3) aufliegt,
- wobei der plattenförmige Leiter (8) ferner auf einer zweiten Kontaktoberfläche des weiteren Transistors (4) aufliegt, welche der äußeren Oberfläche (9) des Energiespeichers (3) abgewandt ist.

## Claims

1. Battery cell (1), comprising:
- a first terminal contact (2a) and a second terminal contact (2b),
- an energy storage unit (3),
- a first transistor (4),
- a sensor system (5) that is set up to acquire a state parameter of the battery cell (1), and
a control circuit (6),
- wherein a first pole (3a) of the energy storage unit is coupled to the first terminal contact (2a), and a second pole (3b) of the energy storage unit (3) is coupled to the second terminal contact (2b),
- wherein the first transistor (4) is connected between the first terminal contact (2a) and the second terminal contact (2b) in series with the energy storage unit (3), and
- wherein the control circuit (6) is set up to control a switching process of the first transistor (4), wherein the control circuit (6) controls the first transistor (4) based on the acquired state parameter in order to control a charge current or a discharge current of the energy storage unit (3),
- a second transistor (7) that is connected between the first terminal contact (2a) and the second terminal contact (2b) in parallel with the energy storage unit (3),
- wherein the control circuit (6) is set up to control a switching process of the second transistor (7),
- wherein the second transistor (7) is, in particular, a thin-film MOSFET transistor, **characterized in that** the control circuit (6) is set up to switch both the first transistor (3) and the second transistor (7) to the on state at the same time in order to heat the battery cell.

2. Battery cell (1) according to Claim 1, wherein the sensor system (5) comprises at least one of a voltage sensor (5a), a current sensor (5b) and a temperature sensor (5c).

3. Battery cell (1) according to either of the preceding claims, wherein the first transistor (3) is a thin-film MOSFET transistor.

4. Battery cell (1) according to one of the preceding claims, wherein the control circuit (6) is set up to control the switching process of the first transistor (3) for controlling the charging current or the discharge current through pulsed switching first transistor (3) or through operating the first transistor (3) in resistor mode.

5. Battery cell (1) according to one of the preceding claims, wherein the control circuit (6) is set up actuate the switching process of the first transistor (3) for controlling the charge current or the discharge current such that cell balancing is carried out.

6. Battery cell (1) according to one of the preceding claims, wherein the control circuit (6) is set up to ascertain a state of charge of the energy storage unit (3), a state of health of the energy storage unit (3) and/or a functional state of the energy storage unit (3).

7. Battery cell (1) according to one of the preceding claims,
- wherein the first transistor (4) is arranged on an outer surface (9) of the energy storage unit (3), wherein a first contact surface of the first transistor (4) rests on the second pole (3b) of the energy storage unit (3),
- wherein a plate-shaped conductor (8) rests on a second contact surface of the first transistor (4) that faces away from the outer surface (9) of the energy storage unit (3), and
- wherein the plate-shaped conductor (8) is electrically connected to the second terminal contact (2b).

8. Battery cell (1) according to Claim 7,
- wherein a further transistor (10) is arranged on the outer surface (9) of the energy storage unit (3), wherein a first contact surface of the further transistor (4) rests on the first pole (3a) of the energy storage unit (3),
- wherein the plate-shaped conductor (8) also rests on a second contact surface of the further transistor (4) that faces away from the outer surface (9) of the energy storage unit (3).

## Revendications

1. Cellule de batterie (1), comprenant :
- un premier contact de raccordement (2a) et un deuxième contact de raccordement (2b),
- un accumulateur d'énergie (3),
- un premier transistor (4),
- un dispositif de détection (5), qui est conçu pour détecter un paramètre d'état de la cellule de batterie (1), et
- un circuit de commande (6),
- un premier pôle (3a) de l'accumulateur d'énergie (3) étant connecté au premier contact de raccordement (2a) et un deuxième pôle (3b) de l'accumulateur d'énergie (3) étant connecté au deuxième contact de raccordement (2b),
- le premier transistor (4) étant branché en série avec l'accumulateur d'énergie (3) entre le premier contact de raccordement (2a) et le deuxième contact de raccordement (2b), et
- le circuit de commande (6) étant conçu pour commander une opération de commutation du premier transistor (4), le circuit de commande (6) commandant le premier transistor (4) en se basant sur le paramètre d'état détecté afin de réguler un courant de charge ou un courant de décharge de l'accumulateur d'énergie (3),
- un deuxième transistor (7), lequel est branché en parallèle avec l'accumulateur d'énergie (3) entre le premier contact de raccordement (2a) et le deuxième contact de raccordement (2b),
- le circuit de commande (6) étant conçu pour commander une opération de commutation du deuxième transistor (7),
- le deuxième transistor (7) étant notamment un MOSFET à film mince, **caractérisée en ce que**
le circuit de commande (6) est conçu pour commuter à la fois le premier transistor (3) et le deuxième transistor (7) simultanément dans un état passant afin de chauffer la cellule de batterie.

2. Cellule de batterie (1) selon la revendication 1, le dispositif de détection (5) comprenant au moins l'un parmi un capteur de tension (5a), un capteur de courant (5b) et un capteur de température (5c).

3. Cellule de batterie (1) selon l'une des revendications précédentes, le premier transistor (3) étant un MOSFET à film mince.

4. Cellule de batterie (1) selon l'une des revendications précédentes, le circuit de commande (6) étant conçu pour réguler l'opération de commutation du premier transistor (3) en vue de réguler le courant de charge ou le courant de décharge par une commutation pulsée du premier transistor (3) ou en faisant fonctionner le premier transistor (3) dans un régime de résistance.

5. Cellule de batterie (1) selon l'une des revendications précédentes, le circuit de commande (6) étant conçu pour commander l'opération de commutation du premier transistor (3) en vue de réguler le courant de charge ou le courant de décharge de telle sorte qu'un équilibrage de cellule est réalisé.

6. Cellule de batterie (1) selon l'une des revendications précédentes, le circuit de commande (6) étant conçu pour identifier un état de charge de l'accumulateur d'énergie (3) et/ou un état de fonctionnement de l'accumulateur d'énergie (3).

7. Cellule de batterie (1) selon l'une des revendications précédentes,
- le premier transistor (4) étant disposé sur une surface extérieure (9) de l'accumulateur d'énergie (3), une première surface de contact du premier transistor (4) reposant sur le deuxième pôle (3b) de l'accumulateur d'énergie (3),
- un conducteur en forme de plaque (8) reposant sur une deuxième surface de contact du premier transistor (4), laquelle est à l'opposé de la surface extérieure (9) de l'accumulateur d'énergie (3), et
- le conducteur en forme de plaque (8) étant relié électriquement au deuxième contact de raccordement (2b).

8. Cellule de batterie (1) selon la revendication 7,
- un transistor supplémentaire (10) étant disposé sur la surface extérieure (9) de l'accumulateur d'énergie (3), une première surface de contact du transistor supplémentaire (10) reposant sur le premier pôle (3a) de l'accumulateur d'énergie (3),
- le conducteur en forme de plaque (8) reposant en outre sur la deuxième surface de contact du transistor supplémentaire (4), laquelle est à l'opposé de la surface extérieure (9) de l'accumulateur d'énergie (3).
